Europäisches Patentamt

European Patent Office

Office européen des brevets

(11) Numéro de publication: **0 230 176 B1**

## (12) FASCICULE DE BREVET EUROPEEN

(45) Date de publication de fascicule du brevet: **03.06.92**   (51) Int. Cl.⁵: **H03F  3/343**, H03K 17/60

(21) Numéro de dépôt: **86402670.3**

(22) Date de dépôt: **02.12.86**

(54) **Relais statique et application de ce relais à un inverseur bipolaire ou à un circuit dans lequel circule un courant de sens quelconque.**

(30) Priorité: **05.12.85 FR 8518016**

(43) Date de publication de la demande:
**29.07.87 Bulletin  87/31**

(45) Mention de la délivrance du brevet:
**03.06.92 Bulletin  92/23**

(84) Etats contractants désignés:
**CH DE FR GB LI NL**

(56) Documents cités:
**FR-A- 2 559 322
GB-A- 888 306
GB-A- 968 475
US-A- 4 380 795**

**ELECTRONICS, vol. 47, no. 20, 3 octobre
1974, page 126, McGraw-Hill, New York, US;
E. BURWEN: "High-gain triple Darlington has
low saturation voltage"**

**ELECTRONIC ENGINEERING, vol. 38, no. 464,
octobre 1966, pages 665-667, Londres, GB; P.
MARS: "Analysis of the complementary pair
emitter-follower"**

(73) Titulaire: **COMMISSARIAT A L'ENERGIE ATO-
MIQUE Etablissement de Caractère Scientifique Technique et Industriel
31/33, rue de la Fédération
F-75015 Paris(FR)**

(72) Inventeur: **Nakach, Alain
16, rue de Frileuse
F-91400 Gometz-la-Ville(FR)**
Inventeur: **Sole, Jean
9, rue de Crillon
F-92210 Saint Cloud(FR)**
Inventeur: **Starzynski, Pierre
26, Avenue Roux
F-77140 Nemours(FR)**

(74) Mandataire: **Mongrédien, André et al
c/o BREVATOME 25, rue de Ponthieu
F-75008 Paris(FR)**

EP 0 230 176 B1

EP 0 230 176 B1

PATENTS ABSTRACTS OF JAPAN, vol. 2, no. 134, 9 novembre 1978, page 8387 E 78; & JP-A-53 103 361 (FUJI DENKI SEIZO K.K.) 08-09-1978

PATENTS ABSTRACTS OF JAPAN, vol. 4, no. 52 (E-7)[534], 18 avril 1980; & JP-A-55 21 677 (TOKYO SHIBAURA DENKI K.K.) 15-02-1980

THE RADIO AND ELECTRONIC ENGINEER, vol. 54, no. 5, mai 1984, pages 219-224, IERE, Londres, GB; D. COLMAN: "An advanced Darlington transistor for switch mode power control"

## Description

La présente invention concerne un relais statique ainsi que l'application de ce relais à un inverseur bipolaire ou à un circuit dans lequel circule un courant de sens quelconque.

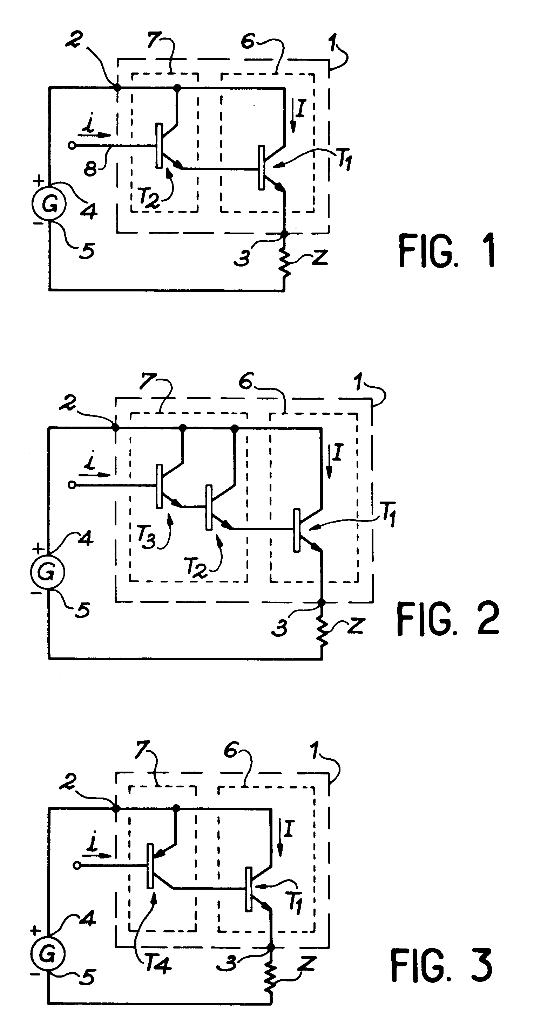

La figure 1 représente schématiquement un montage connu dans l'état de la technique et permettant de réguler la valeur de l'intensité d'un courant circulant dans un circuit d'utilisation (G, Z), au moyen d'un étage amplificateur de courant 1, comprenant une entrée et une sortie 2, 3 de courant. La sortie de l'amplificateur 1 est reliée à une première borne de la charge Z. Le courant est fourni par un générateur G ayant une première borne d'alimentation 4 reliée à l'entrée 2 de l'amplificateur, et une deuxième borne d'alimentation 5 reliée à une deuxième borne de la charge Z. Ce type connu d'amplificateur (montage DARLINGTON) comprend généralement un étage 6 amplificateur de puissance constitué par un transistor T1 de type NPN par exemple, dont le collecteur est relié à l'entrée 2 de l'amplificateur, et dont l'émetteur est relié à la sortie 3 de cet amplificateur. Cet amplificateur comprend aussi un étage 7 de commande du transistor T1 de l'étage de puissance ; ce transistor bipolaire de commande est de même type que celui du transistor de l'étage de puissance (type NPN dans l'exemple considéré). Le collecteur du transistor de commande T2 est relié à l'entrée 2 de l'amplificateur, tandis que l'émetteur de ce transistor est relié à la base du transistor de puissance T1. La base 8 du transistor T2 de commande reçoit un courant d'intensité i qui permet de commander la valeur du courant I circulant dans la charge Z. On suppose bien entendu que la borne 4 d'alimentation du générateur G est une borne de tension positive, tandis que la borne 5 est une borne de tension négative.

Dans ce type connu d'amplificateur de courant, les transistors de puissance et de commande sont de même type. Ce type d'amplificateur présente des inconvénients importants : lorsque le transistor de puissance T1 est à l'état saturé, la chute du potentiel entre les bornes d'entrée et de sortie 2, 3 de l'amplificateur (chute de potentiel entre l'émetteur et le collecteur du transistor de puissance T1) est supérieure à celle qui apparaît normalement entre l'émetteur et le collecteur de ce transistor lorsque sa base n'est pas reliée à un autre transistor pour former un circuit de type Darlington. Ce type d'amplificateur ne peut donc fonctionner correctement si on veut l'utiliser comme un relais.

Cette chute de potentiel devient encore plus importante lorsque plusieurs étages de type Darlington sont montés en cascade, comme représenté schématiquement en exemple sur la figure 2. Les mêmes éléments portent les mêmes références sur cette figure et sur la figure 1. Dans ce montage de type connu, l'amplificateur 1, dont les bornes d'entrée et de sortie sont représentées en 2, 3 comprend un étage de puissance 6 constitué par un transistor de puissance T1 dont le collecteur est relié à l'entrée 2 (borne positive 4 du générateur G), et dont l'émetteur est relié à la charge Z, elle-même reliée à la borne négative 5 du générateur G. Cet amplificateur comprend aussi un étage de commande 7 constitué par un montage Darlington à deux transistors T2, T3 reliés en cascade. Dans ce type de montage, les chutes de potentiel entre l'émetteur et la base de chaque transistor de l'étage de commande s'ajoutent, ce qui fait apparaître entre la base et le collecteur du transistor T1 de l'étage de puissance, une tension au moins égale à la somme de ces chutes de potentiel. Il en résulte que le transistor T1 ne peut fonctionner à son maximum de saturation. Comme c'est précisément à travers le transistor T1 que passe la plus grande fraction du courant I qui alimente la charge Z, et que l'effet Joule dans le transistor T1 est égal au produit du courant qui le traverse par la chute de tension émetteur-collecteur, il en résulte dans les jonctions du transistor T1, un effet Joule considérable pour les valeurs élevées du courant I.

De plus, dans un montage Darlington, la différence de potentiel base-émetteur du transistor T1 de puissance est diminuée du fait de la chute de tension supplémentaire introduite par le transistor de commande T2, et est encore diminuée du fait de la présence du transistor T3 (et des transistors d'étages précédents s'il y a lieu). Il en résulte que le transistor de puissance est en général mal saturé.

Il en résulte que ce montage, comme le précédent ne peut fonctionner correctement en relais.

La figure 3 représente schématiquement un autre type connu d'amplificateur 1 de courant pouvant servir de relais. Cet amplificateur présente une entrée 2 et une sortie 3, la sortie étant reliée à une première borne d'une charge Z. Le courant est fourni par un générateur G ayant une première borne positive d'alimentation 4 reliée à l'entrée 2 de l'amplificateur, et une deuxième borne négative 5, reliée à une autre borne de la charge Z. Cet amplificateur comprend un étage amplificateur de puissance 6 comportant un transistor T1 bipolaire d'un premier type (NPN par exemple). Le collecteur de ce transistor est relié à l'entrée 2 de l'amplificateur, et l'émetteur est relié à la sortie 3 de cet amplificateur. L'amplificateur comprend aussi un étage 7 de commande du transistor de l'étage de puissance ; cet étage de commande est constitué par au moins un transistor bipolaire T4 de commande. Ce transistor T4 est d'un deuxième type (PNP par exemple), opposé au premier type. L'émetteur du transistor T4 est relié à l'entrée 2 de l'amplificateur et le collecteur de ce transistor est relié à la base 10 du transistor T1 de puissance. La base du transistor de commande T4 reçoit un courant de commande i qui détermine l'intensité du courant d'alimentation I de la charge Z. L'impédance de l'étage amplificateur varie en sens inverse de la valeur du courant de commande, comme on le verra plus loin en détail. Dans ce montage, chaque transistor est alimenté par la totalité de la différence de potentiel existant entre l'entrée 2 et la sortie 3 de l'amplificateur, diminuée d'une seule chute de tension émetteur-base pour tous les transistors de commande. Ainsi dans le cas de la figure 3, la différence de potentiel émetteur-base du transistor de puissance T1 se retranche de la différence de potentiel alimentant la jonction émetteur-collecteur du transistor de commande T4. Ce type de montage peut fonctionner en relais. Toutefois, le fonctionnement du transistor de puissance à saturation n'est pas parfait.

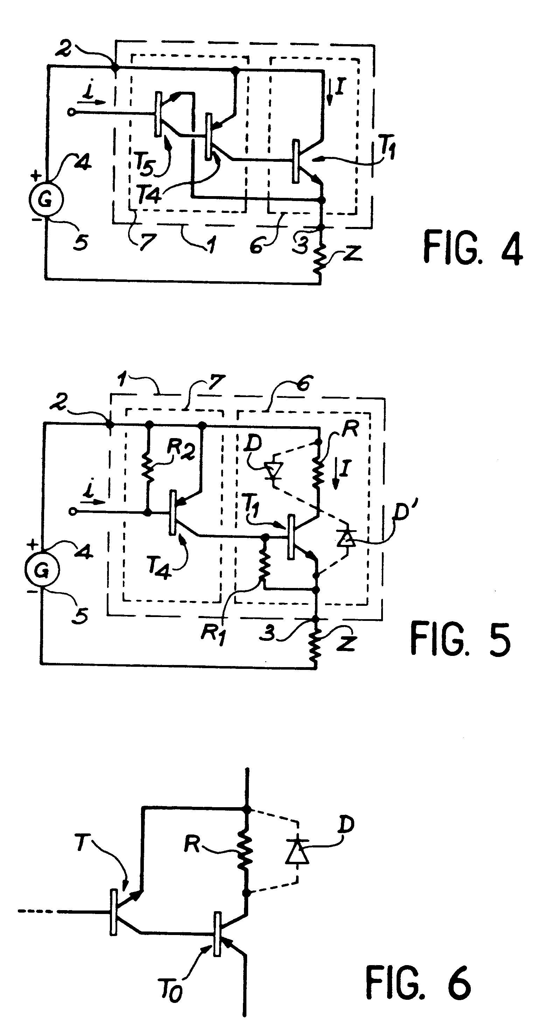

La figure 4 représente schématiquement une variante du montage précédent. Ce montage peut aussi servir de relais. Les mêmes éléments portent les mêmes références sur cette figure et sur la figure 3. L'amplificateur ou relais 1 comprend ici l'étage 6 amplificateur de puissance, constitué par le transistor T1 de type NPN par exemple. L'amplificateur comprend aussi un étage 7 de commande du transistor T1 de l'étage de puissance. L'étage de commande 7 comprend ici deux transistors T4 et T5 de types alternés. Le transistor T4 est de type PNP (puisque le transistor T1 est de type NPN par exemple), tandis que le transistor T5 est de type NPN. Le collecteur du transistor T4 est relié à la base du transistor T1 et le collecteur du transistor T5 est relié à la base du transistor T4. L'émetteur du transistor T4 est relié à la borne positive 4 du générateur 5, et l'émetteur du transistor T5 est relié à la sortie 3 de l'amplificateur. Ce type de montage évite le cumul des chutes de tension émetteur-base observé dans le montage Darlington décrit précédemment. Toutefois, comme dans le montage de la figure 3, le fonctionnement du transistor de puissance à saturation n'est pas parfait.

Un autre type de relais est décrit dans le document GB-A-888 306. Le relais de ce document ne fait pas intervenir de transistors de type alterné et il en résulte que la chute de tensions aux bornes du relais demeure importante.

L'invention a pour but de remédier aux inconvénients des montages qui peuvent fonctionner en relais et notamment de diminuer toute dissipation thermique dans les jonctions du transistor de puissance de ce relais. Elle a aussi pour but d'améliorer le fonctionnement de ce transistor de puissance, notamment à saturation. Ces buts sont atteints notamment en utilisant pour commander l'intensité du courant fourni par le transistor de puissance, au moins un transistor de commande, de type opposé à celui du transistor de puissance et surtout en introduisant une résistance ou une diode en série dans le collecteur du transistor de puissance ; ceci permet comme on le verra plus loin en détail de diminuer encore la chute de potentiel émetteur-collecteur du transistor de puissance, notamment lorsque celui-ci fonctionne à saturation.

L'invention a pour objet on relais autorisant ou interrompant la circulation d'un courant dans un circuit d'utilisation (G, Z), comprenant un étage de puissance (6) comportant au moins un transistor bipolaire de puissance (T1) d'un premier type (NPN ou PNP), ayant son émetteur relié à une première borne (3) du circuit d'utilisation et son collecteur relié, par une impédance (R ou D) de faible valeur, à une deuxième borne (2) du circuit d'utilisation, et un étage amplificateur de commande (7) du transistor de puissance pour autoriser ou interrompre la circulation du courant dans le circuit d'utilisation, cet étage amplificateur comprenant au moins un transistor bipolaire de commande (T4) d'un deuxième type (PNP ou NPN) opposé au premier type, dont l'émetteur est relié à la deuxième borne (2) du circuit d'utilisation et dont le collecteur est relié à la base du transistor (T1) de puissance, la base du transistor de commande recevant un courant (i) de commande déterminant l'intensité du courant d'alimentation (I) du circuit d'utilisation (G, Z), l' impédance de l'étage de puissance variant en sens inverse de la valeur du courant de commande, caractérisé en ce qu'il comporte en outre une résistance (R1) de valeur élevée qui relie la base et l'émetteur du transistor (T1) de l'étage de puissance, pour fixer la tension base-émetteur du transistor de puissance (T1) lorsque le transistor de l'étage (T4) de commande est à l'état bloqué, de sorte que l'alimentation de l'étage de commande est constituée par la connexion de cet étage de commande aux première et deuxième bornes du circuit d'utilisation, l'impédance de faible valeur étant choisie pour que la jonction collecteur-base du transistor de puissance soit polarisée dans le sens direct à saturation, l'étage de commande comportant au moins un autre transistor bipolaire (T5) d'un premier type (NPN ou PNP) dont le collecteur est relié à la base du transistor de commande (T4) et dont l'émetteur est relié à ladite première borne (3), le courant de commande étant appliqué à la base de cet autre transistor bipolaire (T5), le gain de l'étage de commande étant de valeur élevée.

Selon une autre caractéristique, une résistance (R2) de valeur élevée relie éventuellement le base et l'émetteur du transistor de commande (T4).

Selon une autre caractéristique, ladite impédance est une résistance ou une diode branchée pour fonctionner dans le sens direct.

Selon un autre caractéristique, une diode (D') relie le collecteur et l'émetteur du transistor de puissance (T1), cette diode étant reliée en inverse par rapport au sens du courant circulant dans ce transistor de puissance.

Selon une autre caractéristique, une autre résistance de valeur élevée (R3) relie la base et l'émetteur de l'autre transistor bipolaire (T5) de premier type, de l'étage de commande.

Selon autre relais de réalisation, le transistor de l'étage de commande est un phototransistor.

Selon une autre caractéristique, l'étage de puissance comporte au moins un deuxième transistor de puissance relié en parallèle avec le transistor de puissance (T1) qui est relié au circuit d'utilisation (G, Z), ce deuxième transistor de puissance ayant son émetteur relié à la première borne (3) du circuit d'utilisation (G, Z) et son collecteur relié à la deuxième borne de ce circuit d'utilisation par une impédance de faible valeur choisie pour que la jonction collecteur-base de ce deuxième transistor de puissance soit polarisée dans te sens direct à saturation, la base de chaque transistor de puissance étant retiée au collecteur du transistor de commande.

Selon une autre caractéristique, une résistance (R1) de valeur élevée relie les bases et les émetteurs des transistors de puissance.

Selon une autre caractéristique la base de chaque transistor de puissance est reliée au collecteur du transistor de commande, par une résistance (r).

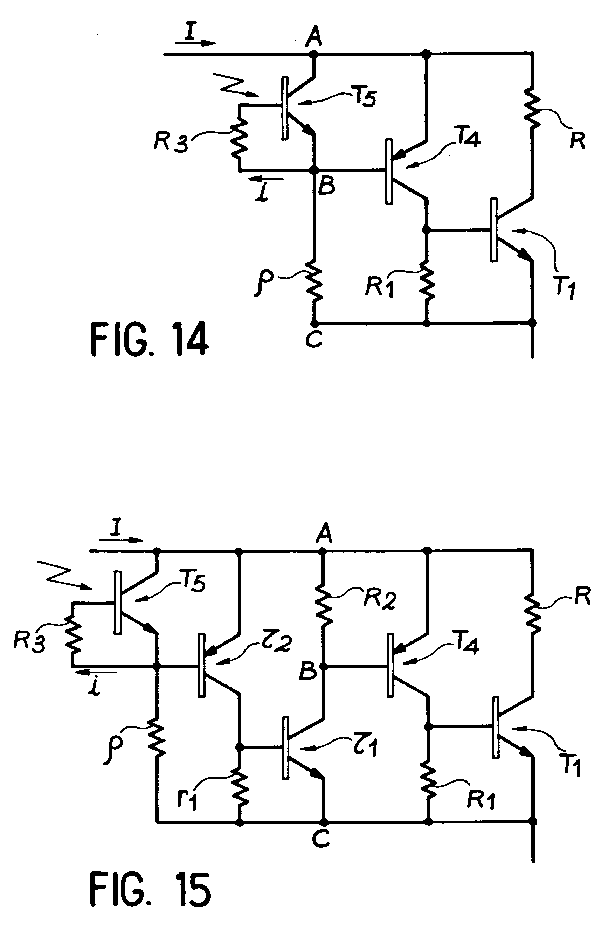

Selon une autre caractéristique l'etage de commande comprend au moins un autre transistor bipolaire (T5 -figure 14, figure 15) branché en émetteur et base du transistor (T4 -figure 14 ou T2 - figure 15) qu'il commande.

L'invention a aussi pour objet un Inverseur bipolaire de courant dans une charge, cet inverseur comprenant quatre relais conformes à t'une quelconque des revendi<ations 1 à 10, disposés respectivement dans quatre branches d'un pont, ld charge étant si tuée dans une diagonale du pont, et te générateur étant disposé dans une autre diagonate du pont.

Enfin, selon une autre caractéristique, à une charge dans laquelle circule un courant de sens quelconque ou un courant atternatif, te retais étant connecté entre deux bornes d'une diagonate d'un pont redresseur à quatre diodes, un générateur de courant de sens quelconque ou un générateur de tension atternative étant relié en série avec la charge entre deux autres bornes d'une autre diagonate du pont redresseur.

Les caractéristiques et avantages de l'invention ressortiront mieux de la description qui va suivre, donnée en référence aux dessins annexés dans lesquels :

- les figures 1 à 4, déjà décrites, représentent des amplificateurs de courant ou des relais de types connus dans l'état de la technique,
- les figures 5,6 et 7 représentent différents modes de réalisation d'un relais et permettent de mieux comprende le fonctionnement du relais de l'invention, décrit aux figures 8 et 9.
- les figures 8 et 9 représentent schématiquement d'autres modes de réalisation d'un relais selon l'invention,
- la figure 10 représente schématiquement un montage inverseur bipolaire dans lequel interviennent des relais conformes à celui de l'invention,
- la figure 11 représente schématiquement un montage permettant de faire circuler un courant de sens quelconque dans une charge, à l'aide d'un relais conforme à l'invention,
- la figure 12 représente un relais dans lequel des transistors de puissance sont reliés en parallèle,
- la figure 13 représente schématiquement un relais selon l'invention, dans lequel les transistors de puissance sont reliés en parallèle,
- les figures 14 et 15 représentent d'autres variantes du relais de l'invention représenté sur la figure 9.

La figure 5 représente schématiquement un mode de réalisation d'un relais-, pour différentes variantes de ce relais. Cette figure permet de mieux comprende le fonctionnement du relais de l'invention, qui sera décrit ulterieurement. Les mêmes éléments portent les mêmes références sur cette figure et sur la figure 3. Dans ce mode de réalisation, le relais comporte un étage de puissance 6 comprenant notamment un transistor T1 de puissance d'un premier type (NPN par exemple), et un étage de commande 7 comprenant notamment un transistor de commande T4 d'un deuxième type (PNP par exemple). Le collecteur du transistor T1 de puissance, est relié, selon l'invention, à une première borne 4 du générateur G, par une impédance de faible valeur, qui sera décrite plus loin en détail. L'émetteur du transistor de puissance est relié à une borne 3 du circuit d'utilisation ou charge Z. Une autre borne de ce circuit d'utilisation est reliée à une deuxième borne 5 du générateur G. On suppose que la première borne 4 de ce générateur, est positive, tandis que la deuxième borne 5 est négative. L'émetteur du transistor T4 de commande est relié à la première borne 4 du générateur, tandis que le collecteur de ce transistor est relié à la base du transistor T1 de puissance. La base du transistor T4 de commande peut recevoir un courant i de commande du courant I pouvant circuler dans la charge Z.

le fonctionnement de ce relais est amélioré grâce à l'impédance de faible valeur reliant le collecteur du transistor de puissance avec la première borne du générateur. Grâce à cette impédance, le transistor T1 de puissance fonctionne bien mieux à saturation, comme on le verra plus loin en détail. Cette impédance peut être constituée selon deux différentes variantes, soit par une résistance R de faible valeur, soit par une diode D dont le sens de conduction est celui du courant dans le transistor T1 de l'étage de puissance. Cette impédance de faible valeur introduit une faible chute de potentiel sur le collecteur du transistor de puissance T1, et il en résulte que ce transistor est alors polarisé par une différence de potentiel émetteur-base, supérieure à la différence de potentiel émetteur-collecteur ; dans ce cas en effet, la différence de potentiel émetteur-base du transistor de puissance T1 est égale à la différence de potentiel émetteur-collecteur de ce transistor, augmentée de la chute de potentiel introduite par l'impédance de faible valeur. Il en résulte une meilleure saturation du transistor T1 qui se traduit par une plus faible chute de potentiel émetteur-collecteur de ce transistor et donc, par une diminution de l'effet Joule dans le transistor T1. Il apparaît par contre un effet Joule dans la résistance R ou dans la diode D, mais cet effet Joule n'est pas gênant car il est facile à dissiper. On n'est pas limité dans ce cas à une aussi faible élévation de température que celle qu'il est interdit de dépasser dans une jonction semiconductrice, sous peine de la détruire. Il est possible d'admettre pour des résistances, des élévations de température beaucoup plus importantes, sans risquer de les endommager. Il est possible notamment dans le cas où la faible impédance est une résistance R, de trouver une valeur optimale de cette résistance.

Selon une variante du mode de réalisation décrit plus haut sur la figure 5, une diode D′ relie le collecteur et l'émetteur du transistor de puissance T1. Cette diode est reliée en inverse par rapport au sens du courant dans ce transistor. Cette diode permet de protéger le transistor de puissance contre tout courant de sens inverse.

Selon une autre variante du mode de réalisation de la figure 5, une résistance R1 de valeur élevée relie la base et l'émetteur du transistor T1 de l'étage de puissance ; cette résistance permet de fixer la tension base-émetteur de ce transistor T1, lorsque le transistor T2 de l'étage de commande est à l'état bloqué. De la même manière, une résistance R2 de valeur élevée peut aussi relier la base et l'émetteur du transistor T2 de l'étage de commande, pour fixer la tension baseémetteur de ce transistor.

On va maintenant mieux expliquer à l'aide de la figure 6, le rôle de la faible impédance introduite, sur le collecteur du transistor T0 de puissance, supposé de type PNP dans l'exemple représenté. Un transistor à jonctions est constitué par deux jonctions consécutives : émetteur-base et base-collecteur, en sens inverse. Le transistor de type PNP représenté fonctionne normalement en polarisant la jonction émetteur-base dans le sens direct (la chute de tension aux bornes de cette jonction est faible), et la jonction base-collecteur dans le sens-inverse (la chute de tension aux bornes de cette jonction est élevée).

Dans ce fonctionnement, si l'on augmente le courant base, (il s'agit en réalité du courant émetteur-base car la jonction base-collecteur est polarisée en inverse), il arrive un moment où le courant collecteur n'augmente presque plus. On dit que le transistor se sature. Dans ce cas la tension émetteur-collecteur devient relativement faible.

Si, pour polariser la base, on ne dispose d'aucune autre source de courant ou de tension autre que les bornes émetteur et collecteur du transistor lui-même (cas du relais), on obtient un courant base de valeur maximum en portant, au mieux, le potentiel de la base au potentiel du collecteur, au moyen d'une connexion reliant la base et le collecteur.

Cette connexion peut être mise en place ou interrompue, au moyen d'un interrupteur mécanique, ou au moyen d'un autre transistor T relié comme le montre la figure 6, que l'on fait fonctionner en saturé (interrupteur fermé) ou bloqué (interrupteur ouvert). Dans ce cas, la tension aux bornes de la jonction base-collecteur du transistor T0 est égale à la tension aux bornes du transistor T.

On peut diminuer encore cette tension base-collecteur du transistor To en polarisant la jonction base-collecteur dans le sens direct. Pour cela il faut introduire une impédance (résistance R, ou diode D dans le sens direct) en série avec le collecteur du transistor To et porter le potentiel de la base de ce transistor au potentiel du point le plus éloigné de cette impédance. Grâce à cette impédance la jonction base-collecteur du transistor To est alors polarisée dans le sens direct quand le transistor To est saturé. Ce transistor fonctionne de manière tout à fait originale.

La tension base-collecteur devient alors extrêmement faible, ce qui réduit l'effet Joule sur cette jonction. La faible chute de tension aux bornes de l'impédance (R ou D) provoque alors dans cette impédance, un faible effet Joule que l'on peut dissiper hors du transistor To avec une surface de refroidissement plus faible que celle qui aurait été nécessaire sur ce transistor pour dissiper la même chaleur puisque l'on peut porter sans danger la température d'une résistance ou d'une diode à une valeur beaucoup plus élevée que celle qu'il ne faut pas dépasser dans la jonction du transistor (si on veut éviter de la détruire).

Le raisonnement ci-dessus est le même pour un transistor de type NPN.

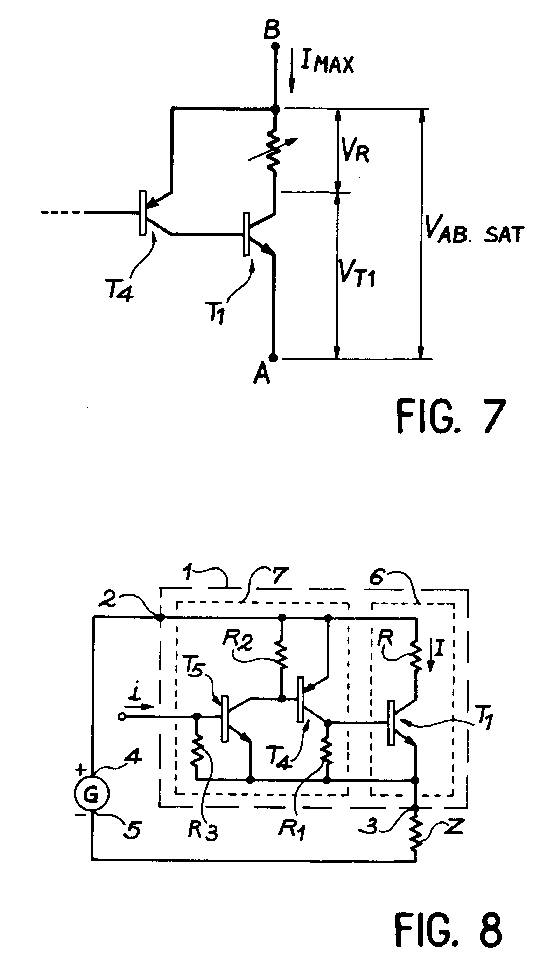

L'optimisation de la valeur de la résistance R reliée au collecteur du transistor T1 de puissance sera mieux comprise à l'aide du montage de la figure 7 où R est une résistance variable pour les besoins du calcul.

Pour R = 0, on mesure la tension aux bornes du relais saturé ($V_{AB.SAT}$) pour le courant $I_{max}$ correspondant à l'échauffement maximum admissible du transistor T1. (Pour R = 0 la jonction base-collecteur du transistor T1 est alors polarisée en inverse). On fait croître la valeur de R jusqu'à la plus grande valeur qui, pour le même courant $I_{max}$, permet de conserver l'ordre de grandeur de la tension $V_{AB.SAT}$ entre les bornes A et B.

On obtient V'$_{AB}$ égale ou très légèrement supérieure à Y$_{AB.SAT}$. La tension émetteur collecteur du transistor T1 est alors $V_{T1} \leq V'_{AB.SAT}$ (et la jonction base-collecteur de T1 est alors polarisée dans le sens direct). Une fraction importante de la tension V'$_{AB.SAT}$ (généralement voisine de 50%) se trouve alors reportée aux bornes de la résistance R. La puissance calorifique correspondante se trouve alors transférée du transistor T1 à cette résistance R.

La forte diminution de puissance calorifique dissipée dans le transistor T1 permet alors soit d'augmenter le courant $I_{max}$ (si l'on ne dépasse pas la limite en courant du transistor utilisé) et il est intéressant de retoucher légèrement dans ce cas la valeur de R, soit de diminuer les dimensions du radiateur de T1, soit de faire le choix d'une combinaison de ces deux possibilités.

La figure 8 représente schématiquement un mode de réalisation du relais de l'invention revendiquée. Les mêmes éléments portent les mêmes références sur cette figure et sur la figure 5. Dans ce mode de réalisation, le relais 1, dont les bornes d'entrée et de sortie sont représentées en 2 et 3, comprend un étage de puissance 6 ; cet étage est constitué par le transistor T1 dont le collecteur est relié à l'entrée 2 du relais par une résistance R de faible valeur, et dont l'émetteur est relié à une borne de la charge ou circuit d'utilisation Z. Le transistor T1 est d'un premier type (NPN par exemple). Le générateur G a une première borne positive 4 qui est reliée à l'entrée 2 de l'amplificateur, tandis que la deuxième borne négative 5 de ce générateur est reliée à une autre borne de ta charge Z. Le relais comprend aussi un étage de commande 7 qui comprend, dans ce mode de réalisation, deux transistors T4, T5 reliés en cascade, respectivement de types complémentaires alternés. C'est ainsi que dans l'exemple représenté sur cette figure, si le transistor T1 est de type NPN, le transistor T4 de l'étage de commande, qui précède le transistor T1 est de type PNP, le transistor T5 qui précède le transistor T4 est de type NPN. Pour les raisons indiquées plus haut, une résistance R1 relie la base et l'émetteur du transistor de puissance T1, une résistance R2 relie la base et l'émetteur du transistor T4, une résistance R3 relie la base à l'émetteur du transistor T5 et une résistance R de faible valeur ou une diode (non représentée) relie le collecteur du transistor T1 à l'entrée 2 de l'amplificateur ; cette résistance ou cette diode est, comme indiqué plus haut, destinée à introduire une faible chute de tension sur le collecteur du transistor de puissance T1. Dans ce montage, les transistors de types complémentaires sont alternés. Le nombre des transistors de types complémentaires dans les étages de puissance et de commande a été limité à trois sur la figure. Il est évident que ce nombre peut être beaucoup plus important et qu'il dépend essentiellement du gain en courant que l'on souhaite obtenir (ce gain en courant est le rapport I/i, I étant le courant circulant dans la charge et i le courant de commande appliqué à la base du transistor de commande T5). Chacun des transistors autres que T1 est toujours alimenté par la différence de potentiel entre l'entrée 2 du relais et la sortie 3 de celui-ci, diminuée de la seule chute de potentiel émetteur-base du transistor commandé. Quel que soit le nombre de transistors constituant le relais, la tension qui apparaît à saturation entre l'entrée et la sortie de ce relais est indépendante du nombre de transistors ; il en résulte que l'effet Joule mentionné plus haut n'est pas modifié, ce qui n'est pas du tout le cas dans le montage des amplificateurs de type Darlington en cascade décrits plus haut.

Le courant i de commande peut être fourni par n'importe quel type de générateur. Tous les transistors sont alimentés par la totalité du courant I débité par le générateur G, de façon que la totalité de ce courant traverse la charge Z. Ce relais peut s'intercaler en n'importe quel point de n'importe quel circuit électrique, sans nécessiter de modification de ce circuit, puisqu'il ne nécessite pas d'alimentation en tension bien définie, pour fonctionner. Il ne possède pas de limite inférieure pour les valeurs de tension ou de courant à commander. Il fonctionne jusqu'à un courant I nul, ce qui n'est pas du tout le cas des relais connus, notamment des montages de type Darlington. Le montage de ce relais peut être qualifié de "flottant" puisqu'il ne nécessite pas de potentiel fixe par rapport à une masse de référence. Il peut ainsi, lorsqu'il fonctionne en commutation, remplacer des relais électromécaniques. Il permet de réaliser un gain en courant aussi élevé qu'on le souhaite puisque le rapport I/i entre le courant I fourni à la charge, et le courant de commande i ne dépend que du nombre de transistors reliés en cascade. Lorsque les transistors sont saturés, la chaleur dissipée sous forme de chaleur est inférieure à celle qui serait dissipée par un montage de type Darlington car, les polarités des transistors utilisés étant alternées, les chutes de tension dans les transistors ne s'ajoutent pas les unes aux autres, chaque transistor utilisant au contraire la totalité de la différence de potentiel apparaissant aux bornes du transistor de puissance T1, et de la résistance R ou de la diode D, diminuée de la seule chute de potentiel émetteur-base du transistor qu'il commande. La majeure partie de l'énergie dissipée sous forme de chaleur est dissipée dans l'impédance de faible valeur qui relie le collecteur du transistor T1 de puissance avec l'entrée du relais comme indiqué plus haut ; cette impédance tolère des élévations de température bien supérieures à celles que peuvent tolérer les jonctions semiconductrices.

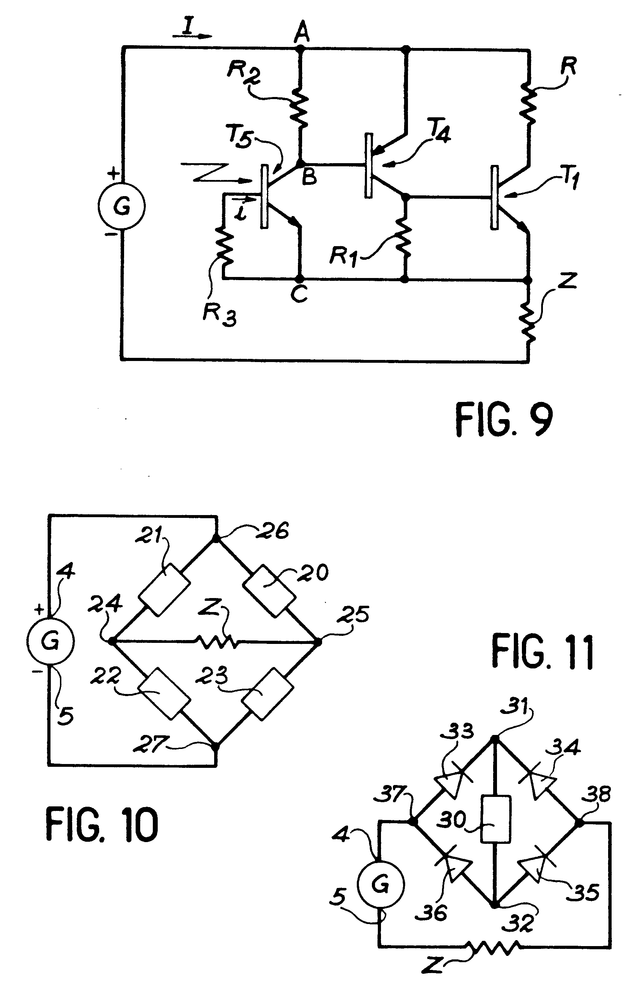

Il est intéressant de mentionner que le courant de base i du premier transistor de commande peut être engendré par un faisceau lumineux ; il suffit dans ce cas, de remplacer le premier transistor de commande par un phototransistor sans rien changer dans le montage qui se comporte de la même façon. Ce type de montage est représenté schématiquement sur la figure 9. Les mêmes éléments portent les mêmes références sur cette figure et sur la figure 8. Le premier transistor T5 de l'étage de commande est un phototransistor qui fournit, lorsqu'il est éclairé, le courant de commande i.

La figure 10 représente schématiquement un inverseur bipolaire de courant dans une charge Z. Cet inverseur bipolaire comprend quatre relais 20, 21, 22, 23 selon l'invention, disposés respectivement dans quatre branches d'un pont. La charge Z est reliée, dans une diagonale du pont, entre deux bornes 24, 25 de ce pont. Le générateur G est relié par ses bornes positive et négative 4, 5 à deux autres bornes 26, 27 d'une autre diagonale du pont. Les relais 20, 21, 22, 23 sont identiques à l'un des relais des figures 5, 8 et 9 décrites plus haut. Si un courant de commande est appliqué au premier transistor de l'étage de commande de chacun des relais 21 et 23 par exemple, il est possible de saturer les transistors correspondants (transistors qui sont bloqués en l'absence de courant) ; tout se passe alors comme si la borne 24 à laquelle est reliée la charge se trouvait reliée au pôle positif 4 du générateur G, et que la borne 25 du pont à laquelle est reliée la charge se trouvait reliée au pôle 5 négatif du générateur. Au contraire, en appliquant un courant de commande sur la base du premier transistor de l'étage de commande de chacun des relais 20, 22, tout se passe comme si la borne 24 à laquelle est reliée la charge Z se trouvait reliée au pôle négatif 5 du générateur G, et comme si la borne 25 du pont à laquelle est reliée la charge se trouvait reliée au pôle positif 4 du générateur G. Le dispositif fonctionne donc comme un inverseur du sens du courant à travers la charge Z. Si aucun courant n'est appliqué sur les bases des transistors de commande de chaque relais, la charge Z n'est pas alimentée et l'inverseur ainsi réalisé est un inverseur à trois états.

La figure 11 représente schématiquement un circuit dans lequel un relais 30 conforme à l'invention (l'un des relais des figures 5, 8 et 9) est utilisé pour faire circuler dans la charge Z un courant alternatif ou un courant de sens quelconque. Le relais 30 est relié entre deux bornes 31, 32 d'une diagonale d'un pont redresseur à quatre diodes 33, 34, 35, 36. Un générateur G d'un courant de sens quelconque ou d'une tension alternative est relié en série avec la charge Z, entre deux autres bornes 37, 38 d'une autre diagonale du pont redresseur. Dans ce montage, bien que le courant fourni par le générateur G soit de sens quelconque ou que la tension fournie par ce générateur soit alternative, le relais 30 est parcouru par un courant de sens constant, tandis que la charge Z est parcourue par un courant de sens variable.

On remarquera que chacun des montages représentés comporte un transistor de puissance de type NPN. Il faut signaler que des montages selon l'invention peuvent être réalisés avec des transistors de puissance de type PNP ; dans ce cas, l'impédance R ou D de faible valeur relie le collecteur T1 à la sortie 3, son émetteur étant réuni à l'entrée 2.

Pour mieux situer l'invention on peut signaler que la chute de potentiel ainsi obtenue aux bornes du transistor de puissance, et donc l'effet Joule, est beaucoup plus faible (facteur pouvant aller de 3 à 5) qu'avec un transistor de puissance à effet de champ.

L'intérêt de l'invention est que l'on peut obtenir le gain en courant souhaité en alternant le nombre de transistors nécessaire sans que les propriétés intéressantes du relais ainsi que son fonctionnement correct ne se dégradent (ce qui ne serait pas possible avec des montages Darlington en cascade). On peut obtenir des gains en courant pratiquement voisins de ceux des relais à transistors à effet de champ. D'autre part, quel que soit le nombre de transistors ainsi reliés, chacun des transistors se trouve alimenté par la différence de potentiel qui apparaît aux bornes du transistor de puissance (augmentée de celle aux bornes de la résistance R ou de la diode D), diminuée de la seule chute de potentiel émetteur-base du transistor directement commandé. Il en résulte que, quel que soit le nombre de transistors de commande, la différence de potentiel aux bornes du transistor de puissance (et donc l'effet Joule) n'augmente pas, suite à un mauvais fonctionnement éventuel des transistors qui le commandent. Tous les transistors fonctionnent correctement jusqu'à un courant I nul, sans qu'il soit nécessaire de faire appel à une alimentation extérieure supplémentaire. Le montage à thyristors par exemple ne fonctionne plus au 1/10e de leur courant maximal.

Le fait de pouvoir obtenir le gain en courant souhaité évite l'utilisation d'un amplificateur de courant extérieur qui, lui, nécessiterait alors une alimentation supplémentaire et poserait des problèmes de liaisons (masse commune, etc...).

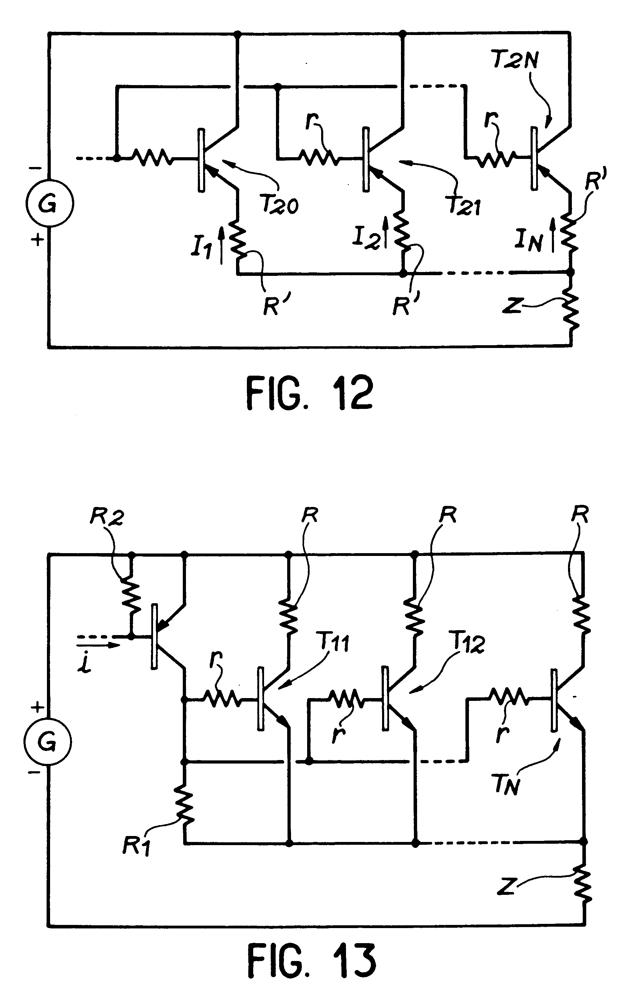

Les figures 12 et 13 vont permettre de mieux comprendre comment à l'aide de l'invention, il est possible d'obtenir un relais statique flottant, pour des courants forts.

La figure 12 représente un relais statique pour courants forts, tel qu'il pourrait être imaginé par l'homme de métier. Sur cette figure on n'a représenté que l'étage de puissance relié au générateur G.

Les courants maxima que peuvent supporter les transistors de puissance étant limités, la solution pour commuter des courants plus importants est de monter plusieurs transistors de puissance en parallèle T21, T22, ..., T2N. Malheureusement, il est bien connu que le fonctionnement des transistors à jonctions en parallèle est relativement instable si l'on ne prend pas la précaution d'introduire, sur chacun de ces transistors une contre-réaction de courant permettant d'équilibrer de façon stable la répartition des courants I1, I2, ..., In entre les différents transistors. Généralement la solution utilisée consiste à introduire, sur chaque transistor, une résistance $R'$ en série avec l'émetteur. Elle stabilise le système en diminuant justement le courant émetteur-base (par diminution de la différence de potentiel émetteur-base) pour les transistors où le courant aurait tendance à être le plus fort. On peut aussi introduire une résistance r en série avec la base de chaque transistor.

La figure 13 montre comment il est possible, selon l'invention, de connecter directement plusieurs étages de puissances en parallèle sans qu'il soit nécessaire d'introduire des résistances en série notamment avec les émetteurs des transistors T11, T12, TN de l'étage de puissance. En effet, les résistances R en série sur les collecteurs, selon l'invention, jouent un rôle stabilisateur analogue sur la répartition du courant entre les différents transistors lorsque ceux-ci sont saturés au point où les deux jonctions émetteur-base et collecteur-base sont polarisées dans le sens direct car dans ce cas, les chutes de tension aux bornes émetteur-collecteur des transistors de puissances sont extrêmement faibles et les courants qui traversent ces transistors deviennent pratiquement déterminés par les résistances R en série sur les collecteurs. Le système est stable : si le courant IN a tendance à augmenter dans le transistor TN, par exemple, la chute de tension R.IN aux bornes de la résistance R augmentera, réduisant la tension disponible aux bornes émetteur-collecteur de ce transistor, et réduisant par conséquent le courant à travers ce transistor. On obtiendra donc une répartition stable du courant total I entre les différents étages de puissance mis en parallèle.

Dans le cadre de l'invention on réalisera par exemple de façon simple un relais 30 ampères en mettant en parallèle trois étages de puissance 10 ampères sans les modifier. Il suffira simplement que le transistor de commande T2 puisse délivrer un courant suffisant pour alimenter les trois bases, en parallèle, des transistors de puissance T11, T12, TN.

Sur cette figure, on retrouve la possibilité d'introduire des résistances émetteur-base telles que R1. On remarquera que pour fixer à l'état bloqué, le potentiel de la base par rapport aux émetteurs de chacun des transistors T11, T12, TN en parallèle, il suffit d'une seule résistance R1. Pratiquement on donnera à cette résistance unique une valeur trois fois plus faible que celle que l'on aurait utilisée sur un seul transistor de puissance, dans le cas où l'on monte trois transistors de puissance en parallèle.

Outre le fait que cette mise en parallèle de trois étages de puissance 10 ampères permet de réaliser un relais statique flottant 30 ampères, avec des transistors supportant 10 ampères au maximum, on peut remarquer que chacun des trois étages de puissances branchés en parallèle n'étant parcourus que par un courant de 10 ampères, la chute de tension aux bornes du relais 30 ampères est la même que celle aux bornes d'un relais 10 ampères.

On a envisagé ici l'exemple de trois étages de puissance en parallèle. On peut, selon ce procédé, envisager un relais comportant N étages de puissance en parallèle (avec $N \geq 2$), et pouvant atteindre des valeurs élevées, par exemple $N = 10$ ou davantage. Dans ce dernier cas le transistor de commande doit être suffisamment puissant pour alimenter toutes les bases en parallèle. On peut également utiliser plusieurs transistors de commande, comme représenté sur les figures 8 et 9 par exemple. On peut aussi prévoir, une résistance r, pour diminuer le courant émetteur-base dans chaque transistor de puissance.

Les relais selon l'invention, qui viennent d'être décrits, sont des relais qui peuvent être qualifiés de relais à contact de "travail" : le contact est "fermé" lorsque le relais est excité.

Le contact dit "au repos" correspond au contact "fermé" lorsque le relais n'est pas excité.

Selon l'invention, à partir des relais précèdents dits à contact de "travail", on peut obtenir des relais à contact "au repos", le contact étant fermé lorsque le relais n'est pas excité.

On sait que l'on peut réaliser une fonction inverse, simplement en inversant le signal de commande du relais.

Mais il est des cas d'utilisation de relais où il est beaucoup plus intéressant de disposer directement de relais possédant un contact "repos" sans que l'on ait à inverser le signal de commande. (Par exemple de tels cas peuvent s'imposer impérativement dans des dispositifs de sécurité où il peut être indispensable de disposer de contacts "repos" en cas de coupure ou de panne dans le circuit de commande du relais.

L'invention permet d'obtenir un relais à contact "repos", à partir des relais à contact "travail" décrits plus haut, moyennant les quelques modifications décrites ci-après.

Si on considère le relais représenté sur la figure 9, la résistance R2 connectée, entre les points A et B, aux bornes émetteur-base du transistor T4, permet d'obtenir le blocage de ce transistor T4 lorsque le phototransistor T5 n'est pas excité (T5 non conducteur). T4 étant bloqué, la résistance R1 bloque T1, et par conséquent, sans excitation, le relais correspond à un contact "ouvert".

Selon l'invention, et tel que représenté sur la figure 14, on remplace la résistance R2 de la figure 9, par le phototransistor T5 muni de la résistance R3, et entre les points B et C, on introduit une résistance $\rho$.

Lorsque T5 n'est par excité, il est bloqué par sa résistance R3, et la jonction émetteur-base de T4 se trouve alimentée, par la tension aux bornes de R et T1, à travers la résistance $\rho$. T4 devient alors conducteur, ce qui rend à son tour T1 conducteur. Donc lorsque T5 n'est pas excité le relais équivaut à un contact "fermé". Il réalise ainsi un contact "repos".

Par contre, lorsque l'on excite T5, T5 devient conducteur et il court-circuite la jonction émetteur-base du transistor T5, suffisamment, pour que T4 se bloque, ce qui bloque T1 et le relais se comporte comme un contact "ouvert".

On a bien inversé les deux états "ouvert" et "fermé" par rapport au cas de la figure 9.

La figure 15 représente la mise en oeuvre pratique du relais de la figure 14.

En effet, sur la figure 14, lorsque T5 est excité, d'une part le relais se comporte comme un contact "ouvert" c'est-à-dire que toute la force électromotrice du générateur G (figure 1) se trouve reportée aux bornes de R et de T1, donc aux bornes AC sur la figure 14, et comme d'autre part T5 est conducteur, cette force électromotrice se trouve reportée aux bornes de $\rho$. Il en résulte le passage d'un courant à travers $\rho$. Ce courant correspond à un courant de fuite du relais dans l'état "ouvert".

Pour réduire ce courant de fuite on augmente la valeur de $\rho$ (par exemple $\rho = 15M\Omega$ pour un relais 150 volts, ce qui donnera un courant de fuite de $10\mu A$).

Mais avec de telles valeurs de $\rho$, lorsque T5 n'est pas excité (T5 non conducteur) le courant base de T4 est très faible et ne permet pas de saturer T4, ce qui ne permet pas de saturer T1.

Pour résoudre ce problème, il suffit (pour $\rho = 15M\Omega$) d'ajouter entre $\rho$ et T5 d'une part, et T4 d'autre part, deux étages amplificateurs comportant notamment les transistors $\zeta1$ et $\zeta2$ tels que décrits plus haut alimentés par la différence de potentiel apparaissant aux bornes de R et T1). On obtient alors un relais à contact "repos" qui fonctionne absolument correctement. On obtient selon que T5 est excité ou non, un blocage, ou une saturation correcte de T1 ; il n'est pas utile d'introduire d'autres éléments de corrections dans ce montage qui se suffit entièrement à lui-même.

Des combinaisons de relais à contacts "travail" et à contacts "repos" peuvent bien entendu être effectuées dans le montage de la figure 10.

## Revendications

1. Relais autorisant ou interrompant la circulation d'un courant dans un circuit d'utilisation (G, Z), comprenant un étage de puissance (6) comportant au moins un transistor bipolaire de puissance (T1) d'un premier type (NPN ou PNP), ayant son émetteur relié à une première borne (3) du circuit d'utilisation et son collecteur relié, par une impédance (R ou D) de faible valeur, à une deuxième borne (2) du circuit d'utilisation, et un étage amplificateur de commande (7) du transistor de puissance pour autoriser ou interrompre la circulation du courant dans le circuit d'utilisation, cet étage amplificateur comprenant au moins un transistor bipolaire de commande (T4) d'un deuxième type (PNP ou NPN) opposé au premier type, dont l'émetteur est relié à la deuxième borne (2) du circuit d'utilisation et dont le collecteur est relié à la base du transistor (T1) de puissance, la base du transistor de commande recevant un courant (i) de commande déterminant l'intensité du courant d'alimentation (I) du circuit d'utilisation (G, Z), l'impédance de l'étage de puissance variant en sens inverse de la valeur du courant de commande, caractérisé en ce qu'il comporte en outre une résistance (R1) de valeur élevée qui relie la base et l'émetteur du transistor (T1) de l'étage de puissance, pour fixer la tension base-émetteur du transistor de puissance (T1) lorsque le transistor de l'étage (T4) de commande est à l'état bloqué, de sorte que l'alimentation de l'étage de commande est constituée par la connexion de cet étage de commande aux première et deuxième bornes du circuit d'utilisation, l'impédance de faible valeur étant choisie pour que la jonction collecteurbase du transistor de puissance soit polarisée dans le sens direct à saturation, l'étage de commande comportant au moins un autre transistor bipolaire (T5) d'un premier type (NPN ou PNP) dont le collecteur est relié à la base du transistor de commande (T4) et dont l'émetteur est relié à ladite première borne (3), le courant de commande étant appliqué à la base de cet autre transistor bipolaire (T5), le gain de l'étage de commande étant de valeur élevée.

2. Relais selon la revendication 1, caractérisé en ce qu'une résistance (R2) de valeur élevée relie éventuellement la base et l'émetteur du transistor de commande (T4).

3. Relais selon la revendication 1, caractérisé en ce que ladite impédance est une résistance ou une diode branchée pour fonctionner dans le sens direct.

4. Relais selon la revendication 1, caractérisé en ce qu'une diode (D') relie le collecteur et l'émetteur du transistor de puissance (T1), cette diode étant reliée en inverse par rapport au sens du courant circulant dans ce transistor de puissance.

5. Relais selon la revendication 2, caractérisé en ce qu'une autre résistance de valeur élevée (R3) relie la base et l'émetteur de l'autre transistor bipolaire (T5) de premier type, de l'étage de commande.

6. Relais selon la revendication 1, caractérisé en ce que le transistor de l'étage de commande est un phototransistor.

7. Relais selon la revendication 1, caractérisé en ce que l'étage de puissance comporte au moins un deuxième transistor de puissance relié en parallèle avec le transistor de puissance (T1) qui est relié au circuit d'utilisation (G, Z), ce deuxième transistor de puissance ayant son émetteur relié à la première borne (3) du circuit d'utilisation (G, Z) et son collecteur relié à la deuxième borne de ce circuit d'utilisation par une impédance de faible valeur choisie pour que la jonction collecteur-base de ce deuxième transistor de puissance soit polarisée dans le sens direct à saturation, la base de chaque transistor de puissance étant reliée au collecteur du transistor de commande.

8. Relais selon la revendication 7, caractérisé en ce qu'une résistance (R1) de valeur élevée relie les bases et les émetteurs des transistors de puissance.

9. Relais selon la revendication 7, caractérisé en ce que la base de chaque transistor de puissance est reliée au collecteur du transistor de commande, par une résistance (r).

10. Relais selon la revendication 1, caractérisé en ce que l'étage de commande comprend au moins un autre transistor bipolaire (T5 -figure 14, figure 15) branché en émetteur et base du transistor (T4 - figure 14 ou $r2$ - figure 15) qu'il commande.

11. Inverseur bipolaire de courant dans une charge, cet inverseur comprenant quatre relais conformes à l'une quelconque des revendications 1 à 10, disposés respectivement dans quatre branches d'un pont, la charge étant située dans une diagonale du pont, et le générateur étant disposé dans une autre diagonale du pont.

12. Application du relais conforme à l'une quelconque des revendications 1 à 10, à une charge dans laquelle circule un courant de sens quelconque ou un courant alternatif, le relais étant connecté entre deux bornes d'une diagonale d'un pont redresseur à quatre diodes, un générateur de courant de sens quelconque ou un générateur de tension alternative étant relié en série avec la charge entre deux autres bornes d'une autre diagonale du pont redresseur.

## Claims

1. Relay authorizing or stopping the flow of a current in a load circuit (G, Z) having a power stage (6) with at least one bipolar power transistor (T1) of a first type (NPN or PNP), whose emitter is connected to a first terminal (3) of the load circuit and whose collector is connected across a low value impedance (R or D) to a second terminal (2) of said load circuit, and a control amplifier stage (7) of the power transistor in order to authorize or stop the flow of current th the load circuit, said amplifier stage having at least one bipolar control transistor (T4) of a second type (PNP or NPN) opposite to the first type, whose emitter is connected to the second terminal (2) of the load circuit and whose collector is connected to the base of the power transistor (T1), the base of the control transistor receiving a control current (i) determining the intensity of the supply current (I) of the load circuit (G, Z), the impedance of the power stage varying in the reverse direction to the value of the control current, characterized in that it also has a high value resistor (R1) connecting the base and emitter of the transistor (T1) of the power stage, in order to fix the base-emitter voltage of the power transistor (T1) when the transistor of the control stage (T4) is in the blocked state, so that the supply of the control stage is constituted by the connection of said stage to the first and second terminals of the load circuit, the low value impedance being chosen in such a way that the collector-base junction of the power transistor is polarized in the forward direction on saturation, the control stage having at least one other bipolar transistor (T5) of a first type (NPN or PNP), whose collector is connected to the base of the control transistor (T4) and whose emitter is connected to the first terminal (3), the control current being applied to the base of said other bipolar transistor (T5), the gain of the control stage being of high value.

2. Relay according to claim 1, characterized in that a high value resistor (R2) optionally connects the base and emitter of the control transistor (T4).

3. Relay according to claim 1, characterized in that the impedance is a resistor or diode connected so as to operate in the forward direction.

4. Relay according to claim 1, characterized in that a diode (D') connects the collector and emitter of the power transistor (T1), said diode being connected in reverse with respect to the direction of the current flowing in said power transistor.

5. Relay according to claim 2, characterized in that another high value resistor (R3) connects the base and emitter of the other bipolar transistor (T5) of the first type of the control stage.

6. Relay according to claim 1, characterized in that the transistor of the control stage is a phototransistor.

7. Relay according to claim 1, characterized in that the power stage has at least one second power transistor connected in parallel with the power transistor (T1) connected to the load circuit (G, Z), said second power transistor having its emitter connected to the first terminal (3) of the load circuit (G, Z) and its collector connected to the second terminal of said load circuit by a low value impedance chosen so that the collector-base of said second power transistor is polarized in the forward direction on saturation, the base of each power transistor being connected to the collector of the control transistor.

8. Relay according to claim 7, characterized in that a high value resistor (R1) connects the bases and emitters of the power transistors.

9. Relay according to claim 7, characterized in that the base of each power transistor is connected to the collector of the control transistor by a resistor (r).

10. Relay according to claim 1, characterized in that the control stage comprises at least one other bipolar transistor (T5 fig. 14, fig. 15) connected in emitter and base of the transistor (T4, fig. 14 or T2, fig. 15) which it controls.

11. Bipolar current inverter in a load, said inverter comprising four relays according to any one of the claims 1 to 10, respectively arranged in four branches of a bridge, the load being located in a diagonal of the bridge and the generator in another diagonal of the bridge.

12. Application of the relay according to any one of the claims 1 to 10 to a load in which flows a current in a random direction or an alternating current the relay being connected between two terminals of a diagonal of a rectifier bridge having four diodes, a random direction current generator or an a.c. voltage generator being connected in series with the load between two other terminals of another diagonal of the rectifier bridge.

**Patentansprüche**

1. Relais, das den Stromfluß in einem Verbraucherstromkreis (G, Z) gestattet oder unterbricht, das wenigstens eine Leistungsstufe (6) mit wenigstens einem Leistungsbipolartransistor (T1) eines ersten Typs (NPN oder PNP) umfaßt, dessen Emitter mit einem ersten Anschluß (3) des Verbraucherstromkreises und dessen Kollektor über eine Impedanz (R oder D) geringen Wertes mit einem zweiten Anschluß (2) des Verbraucherstromkreises verbunden sind, und eine Verstärkerstufe zur Steuerung (7) des Leistungstransistors umfaßt, um den Stromfluß in dem Verbraucherstromkreis zu gestatten oder zu unterbrechen, wobei die Verstärkerstufe wenigstens einen Steuerungsbipolartransistor (T4) eines zweiten Typs (PNP oder NPN), der dem ersten Typ entgegengesetzt ist, umfaßt, wobei die Basis des Steuerungstransistors einen Steuerungsstrom (i) erhält, der die Intensität des Versorgungsstroms (I) des Verbraucherstromkreises (G, Z) bestimmt, wobei die Impedanz der Leistungsstufe sich umgekehrt zum Wert des Steuerungsstroms ändert, dadurch gekennzeichnet, daß es außerdem einen Widerstand (R1) mit einem hohen Wert umfaßt, der die Basis und den Emitter des Transistors (T1) der Leistungsstufe verbindet, um die Basis-Emitter-Spannung dieses Leistungstransistors (T1) festzulegen, wenn der Transistor (T4) der Steuerungsstufe im gesperrten Zustand ist, so daß die Versorgung der Steuerungsstufe aus der Verbindung dieser Steuerungsstufe mit den ersten und zweiten Anschlüssen des Verbraucherstromkreises besteht, wobei die Impedanz geringen Wertes so ausgewählt wird, daß der Kollektor-Basis-Übergang des Leistungstransistors in Vorwärtsrichtung in Sättigung vorgespannt ist, wobei die Steuerungsstufe wenigstens einen weiteren Bipolartransistor (T5) eines ersten Typs (NPN oder PNP) aufweist, dessen Kollektor mit der Basis des Steuerungstransistors (T4) und dessen Emitter mit dem ersten Anschluß (3) verbunden ist, wobei der Steuerungsstrom an die Basis dieses weiteren Bipolartransistors (T5) angelegt wird, wobei die Verstärkung der Steuerungsstufe von einem hohen Wert ist.

2. Relais nach Anspruch 1, dadurch gekennzeichnet, daß ein Widerstand (R2) von hohem Wert eventuell die Basis und den Emitter des Steuerungstransistors (T4) verbindet.

3. Relais nach Anspruch 1, dadurch gekennzeichnet, daß die Impedanz ein Widerstand oder eine Diode ist, die so angeschlossen ist, daß sie in Vorwärtsrichtung arbeitet.

4. Relais nach Anspruch 1, dadurch gekennzeichnet, daß eine Diode (D') den Kollektor und den Emitter des Leistungstransistors (T1) verbindet, wobei diese Diode in Rückwärtsrichtung bezüglich des in diesem Leistungstransistor fließenden Stroms angeschlossen ist.

5. Relais nach Anspruch 2, dadurch gekennzeichnet, daß ein weiterer Widerstand (R3) hohen Werts die Basis und den Emitter des weiteren Bipolartransistors (T5) des ersten Typs der Steuerungsstufe verbindet.

6. Relais nach Anspruch 1, dadurch gekennzeichnet, daß der Transistor der Steuerungsstufe ein Phototransistor ist.

7. Relais nach Anspruch 1, dadurch gekennzeichnet, daß die Leistungsstufe wenigstens einen zweiten Leistungstransistor umfaßt, der parallel zum Leistungstransistor (T1) angeschlossen ist, der mit dem Verbraucherstromkreis (G, Z) verbunden ist, wobei dieser zweite Leistungstransistor seinen Emitter mit dem ersten Anschluß (3) des Verbraucherstromkreises (G, Z) und seinen Kollektor über eine Impedanz geringen Werts, die so gewählt ist, daß der Kollektor-Basis-Übergang dieses zweiten Leistungstransistors in Vorwärtsrichtung in Sättigung vorgespannt ist, mit dem zweiten Anschluß des Verbraucherstromkreises verbunden hat, wobei die Basis jedes Leistungstransistors mit dem Kollektor des Steuerungstransistors verbunden ist.

8. Relais nach Anspruch 7, dadurch gekennzeichnet, daß ein Widerstand (R1) hohen Werts die Basen und Emitter der Leistungstransistoren verbindet.

9. Relais nach Anspruch 7, dadurch gekennzeichnet, daß die Basis jedes Leistungstransistors mit dem Kollektor des Steuerungstransistors über einen Widerstand (r) verbunden ist.

10. Relais nach Anspruch 1, dadurch gekennzeichnet, daß die Steuerungsstufe wenigstens einen weiteren Bipolartransistor (T5 - Figur 14, Figur 15) umfaßt, der mit Emitter und Basis des Transistors (T4 - Figur 14 oder τ2 - Figur 15), der ihn steuert, verbunden ist.

11. Bipolarer Inverter für den Strom in einer Last, wobei dieser Inverter vier Relais nach einem der Ansprüche 1 bis 10 umfaßt, die jeweils in vier Zweigen einer Brücke angeordnet sind, wobei sich die Last in einer Diagonalen der Brücke befindet und der Generator in einer anderen Diagonalen der Brücke angeordnet ist.

12. Anwendung des Relais nach einem der Ansprüche 1 bis 10 auf eine Last, in der ein Strom in beliebiger Richtung oder ein Wechselstrom fließt, wobei das Relais zwischen zwei Anschlüssen einer Diagonalen einer Gleichrichterbrücke mit vier Dioden angeschlossen ist, wobei ein Stromgenerator für eine beliebige Richtung oder ein Wechselspannungsgenerator in Reihe mit der Last zwischen zwei weiteren Anschlüssen einer anderen Diagonalen der Gleichrichterbrücke angeschlossen ist.

FIG. 1

FIG. 2

FIG. 3

FIG. 4

FIG. 5

FIG. 6

FIG. 7

FIG. 8

FIG. 9

FIG. 10

FIG. 11

EP 0 230 176 B1

FIG. 12

FIG. 13

18

FIG. 14

FIG. 15